# EUROPEAN PATENT SPECIFICATION

(11) **EP 3 223 317 B1**
(45) Date of publication and mention of the grant of the patent: **23.01.2019**
(21) Application number: 16161321.1
(22) Date of filing: 21.03.2016
(51) Int. Cl.: H01L 31/0216, H01L 31/167

(54) **OPTOCOUPLER**
OPTOKOPPLER
OPTOCOUPLEUR

(43) Date of publication of application: 27.09.2017
(73) Proprietor: Pepperl + Fuchs GmbH, 68307 Mannheim (DE)
(72) Inventor: OFENLOCH, Thomas, 65428 Rüsselsheim (DE)
(74) Representative: Hamel, Armin

(56) References cited:
- WO-A1-2015/076750
- DE-A1- 3 526 001
- JP-A- 2014 099 468
- US-A1- 2011 186 736
- US-A1- 2011 297 831
- US-A1- 2011 297 832
- US-A1- 2013 292 706
- US-A1- 2014 054 614
- US-A1- 2014 091 326

## Description

The invention relates to an optocoupler as defined in claim 1 comprising a transmitter as well as a receiver optically connected with one another and disposed in a housing comprising a transparent housing wall.

An optocoupler is a component of optoelectronics. It serves for transmitting a signal between two electrically isolated circuits. An optocoupler is conventionally comprised of a light-emitting diode (LED) or a laser diode (LD) as the optical transmitter and a photodiode or a phototransistor as the optical receiver. The optically coupled transmitter component and receiver component are located in a housing opaque to incident light.

Conventional optocouplers include an opaque housing in the form of a bulky metal casing or in the form of an equally bulky combination comprised of an inner housing of a synthetic material that is transparent to the infrared light used for the transmission, which housing is intended for receiving or for mounting the transmitter and the receiver, and an additional outer synthetic housing transparent in the infrared range.

From US 2014/054614 A1 there is known a semiconductor device which includes a light-emitting element, a light-receiving element, a primary side lead electrically connected to the light-emitting element, a secondary side lead electrically connected to the light-receiving element and a molded body. The molded body includes an internal resin, an external resin and a light shielding layer. The internal resin covers a portion fixed with the light-emitting element of the primary side lead and a portion fixed with the light-receiving element of the secondary side lead. The external resin covers the internal resin, and shields external light to which the light-receiving element is sensitive. The light shielding layer is provided at a position closer to the second surface than any of the light-emitting element, the light-receiving element, the primary side lead, and the secondary side lead, and shielding the external light.

DE 35 26 001 A1 introduces an optocoupler comprising the discretely encapsulated transmitter and receiver components, which are located opposite one another in a radially spring-loaded sleeve made of glass, plastic, ceramics or preferably metal.

The purpose of these dispositions is to protect the transmission path against external irradiation in order not to "transmit" false signals. However, this assembly is mechanically formidable and complexly structured because of the inner as well as the outer synthetic housing.

The present invention addresses the problem of providing an optocoupler that has a simple structure and is also not prone to interference by infrared radiation.

This problem is resolved by the optocoupler described in claim 1.
[A01] The invention thus relates to an optocoupler comprising a transmitter as well as a receiver which are optically connected with one another. The transmitter as well as the receiver are embedded in a housing comprised of a housing wall which is transparent and thus permeable to light. The housing comprises at least one coating that is opaque to infrared radiation so that no infrared radiation can penetrate into the housing from the outside. The housing comprises an inner region which is divided into a first subsection and a second subsection, wherein the transmitter is located in the first subsection and the receiver is located in the second subsection and wherein between the first subsection and the second subsection a separating wall is provided which is transparent to light so that the transmitter can communicate with the receiver, wherein the separating wall is comprised of the same material as the housing wall and the coating is applied on an outer side of the housing wall of the housing. Since no infrared radiation can reach the inside of the housing, this optocoupler is not prone to interference due to infrared radiation. A further advantage comprises that the optocoupler is of simple structure and can be small-dimensioned since only one housing is provided that has a housing wall and since onto this housing wall a coating opaque to infrared radiation is applied. Further restructuring or retrofitting measures do not need to be undertaken since it is not necessary to equip the optocoupler with an inner and an outer housing. The housing of the optocoupler consequently can simply be provided with at least one coating before the transmitter and the receiver are installed in the housing.
[A02] The at least one coating is preferably an absorption layer. This coating consequently absorbs infrared ration. As the absorption layer are preferably utilized suitable lacquers or varnishes comprising, for example, a 2k polyurethane acrylic system. This system involves a coating that has a simple structure and, at the same time, can be applied quickly yet provides optimum protection against infrared radiation.
[A03] In a further, preferred embodiment the at least one coating is a reflection layer reflecting the infrared radiation. As the reflection layer preferably lacquers or varnishes are employed. Such a coating is cost-effective and can be simply structured.
[A05] The coating is preferably a lacquer or varnish layer. Such a lacquer or varnish layer is fairly cost-effective and can especially simply be applied onto the housing wall.

An embodiment example is described in further detail in the following in conjunction with Figures. In the drawing depict:
- Figure 1: a perspective view onto an optocoupler and
- Figure 2: a section A-A through the optocoupler depicted in Figure 1.

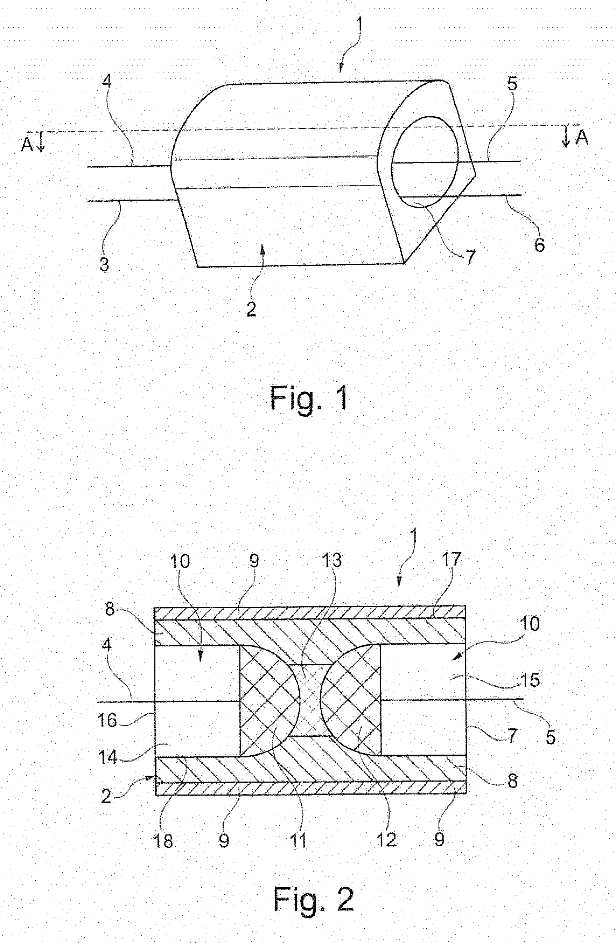

Figure 1 shows a perspective view onto an optocoupler 1. The optocoupler 1 comprises a housing 2 with a housing wall 8 comprised of a transparent material. The housing wall 8 is preferably comprised of a synthetic material, such as for example acrylic resin, transparent to light. In an interior region of the housing 2 a transmitter and a receiver are provided, which, however, are not visible. From the housing 2 two terminals 3, 4 of the transmitter and two terminals 5, 6 of the receiver project from apertures of housing 2. However, in Figure 1 only the aperture 7 can be seen.

The transmitter is preferably an optical transmitter which can be a light-emitting diode (LED) or a laser diode (LD). The receiver involves an optical receiver, preferably a photodiode or a phototransistor.

In Figure 2 is depicted a section A-A through the optocoupler 1 shown in Figure 1. The housing 2 has two oppositely located apertures 7, 16 from which the corresponding terminals of transmitter 11 or of receiver 12 can extend from housing 2. However, the section only shows terminal 4 of the transmitter 11 as well as terminal 5 of the receiver 12. The housing 2 comprises the housing wall 8 comprised of a transparent material, preferably of a transparent synthetic material. Since this housing wall 8 is transparent to infrared radiation, an outer coating 9 is applied onto this housing wall 8. This coating 9 is opaque to infrared radiation.

The infrared radiation-opaque coating can be a lacquer or varnish layer which absorbs or reflects infrared radiation. Housing 2 comprises an inner region 10 which is divided into a first subsection 14 and a second subsection 15. In the first subsection 14 is located the transmitter 11 and in the second subsection 15 the receiver 12. Between the first subsection 14 and the second subsection 15 a separating wall 13 is provided which is transparent to light and, in particular, to infrared radiation so that the optical transmitter 11 can communicate with the optical receiver 12. The separating wall 13 is herein comprised of the same material as the housing wall 8. To prevent the transmitter 11 and the receiver 12 from sliding in the interior region 10 of housing 2, the interior region 10 is developed such that transmitter 11 as well as receiver 12 are clamped in housing 2 and are thus fixed.

The housing 2 includes a first aperture 7 as well as a second, oppositely located aperture 16 out of which the corresponding terminals of the transmitter 11 or of the receiver 12 can reach into the housing 2.

The coating 9 is applied on an outer side 17 of housing wall 8 of housing 2 as is shown in Figure 2.

It is also feasible for a coating opaque to infrared radiation to be provided on the outer side 17 as well as also on the inner side 18 of housing wall 8 in order to ensure even better protection against infrared radiation. However, such is not shown in Figure 2.

Since no infrared radiation can penetrate into the interior region 10 of housing 2 and therefore can also not reach the receiver 12 or the transmitter 11, this optocoupler 1 is not prone to interference with respect to infrared radiation.

### List of Reference Numbers

- 1: Optocoupler
- 2: Housing
- 3: Terminal of transmitter
- 4: Terminal of transmitter
- 5: Terminal of receiver
- 6: Terminal of receiver
- 7: Aperture
- 8: Housing wall
- 9: Coating opaque to infrared radiation
- 10: Interior region
- 11: Transmitter
- 12: Receiver
- 13: Separating wall
- 14: First subsection
- 15: Second subsection
- 16: Aperture
- 17: Outer side
- 18: Inner side

## Claims

1. Optocoupler (1) comprising a transmitter (11) as well as a receiver (12) optically connected with one another and disposed in a housing (2) that includes a housing wall (8) transparent to light, wherein on the housing wall (8) at least one coating (9) is applied, wherein the at least one coating (9) is opaque to infrared radiation, wherein the housing (2) comprises an inner region (10) which is divided into a first subsection (14) and a second subsection (15), wherein the transmitter (11) is located in the first subsection (14) and the receiver (12) is located in the second subsection (15) and wherein between the first subsection (14) and the second subsection (15) a separating wall (13) is provided which is transparent to light so that the transmitter (11) can communicate with the receiver (12), wherein the separating wall (13) is comprised of the same material as the housing wall (8) and the coating (9) is applied on an outer side (17) of the housing wall (8) of the housing (2).

2. Optocoupler as in claim 1, **characterized in that** the at least one coating (9) is an absorption layer.

3. Optocoupler as in claim 1, **characterized in that** the at least one coating (9) is a reflection layer.

4. Optocoupler as in claim 1, **characterized in that** the coating (9) is a lacquer or varnish layer.

## Patentansprüche

1. Optokoppler (1), der einen Sender (11) sowie einen Empfänger (12) umfasst, die optisch miteinander verbunden sind und in einem Gehäuse (2) angeordnet sind, das eine Gehäusewand (8) beinhaltet, die für Licht transparent ist, wobei auf der Gehäusewand (8) wenigstens eine Beschichtung (9) aufgebracht ist, wobei die wenigstens eine Beschichtung (9) für Infrarotstrahlung undurchlässig ist, wobei das Gehäuse (2) ein Innengebiet (10) umfasst, das in ein erstes Untergebiet (14) und ein zweites Untergebiet (15) aufgeteilt ist, wobei sich der Sender (11) in dem ersten Untergebiet (14) befindet und sich der Empfänger (12) in dem zweiten Untergebiet (15) befindet und wobei zwischen dem ersten Untergebiet (14) und dem zweiten Untergebiet (15) eine Trennwand (13) angeordnet ist, die für Licht transparent ist, so dass der Sender (11) mit dem Empfänger (12) kommunizieren kann, wobei die Trennwand (13) aus dem gleichen Material wie die Gehäusewand (8) besteht und die Beschichtung (9) auf eine Außenseite (17) der Gehäusewand (8) des Gehäuses (2) aufgebracht ist.

2. Optokoppler nach Anspruch 1, **dadurch gekennzeichnet, dass** die wenigstens eine Beschichtung (9) eine Absorptionsschicht ist.

3. Optokoppler nach Anspruch 1, **dadurch gekennzeichnet, dass** die wenigstens eine Beschichtung (9) eine Reflexionsschicht ist.

4. Optokoppler nach Anspruch 1, **dadurch gekennzeichnet, dass** die Beschichtung (9) eine Lack- oder Firnisschicht ist.

## Revendications

1. Optocoupleur (1) comprenant un émetteur (11) ainsi qu'un récepteur (12) reliés optiquement l'un à l'autre, et disposés dans un boîtier (2) qui comprend une paroi de boîtier (8) transparente à la lumière, où, sur la paroi de boîtier (8), au moins un revêtement (9) est appliqué, où l'au moins un revêtement (9) est opaque au rayonnement infrarouge, le boîtier (2) comprenant une région interne (10) qui est divisée en une première sous-section (14) et une seconde sous-section (15), où l'émetteur (11) est situé dans la première sous-section (14) et le récepteur (12) est situé dans la seconde sous-section (15), et où, entre la première sous-section (14) et la seconde sous-section (15) est pourvue une paroi de séparation (13) qui est transparente à la lumière de manière à ce que l'émetteur (11) puisse communiquer avec le récepteur (12), la paroi de séparation (13) étant réalisée dans le même matériau que la paroi de boîtier (8), et le revêtement (9) est appliqué sur une face extérieure (17) de la paroi de boîtier (8) du boîtier (2).

2. Optocoupleur selon la revendication 1, **caractérisé en ce que** l'au moins un revêtement (9) est une couche d'absorption.

3. Optocoupleur selon la revendication 1, **caractérisé en ce que** l'au moins un revêtement (9) est une couche réfléchissante.

4. Optocoupleur selon la revendication 1, **caractérisé en ce que** le revêtement (9) est une couche de laque ou de vernis.
